# EUROPEAN PATENT SPECIFICATION

(11) **EP 2 828 899 B1**
(45) Date of publication and mention of the grant of the patent: **26.12.2018**
(21) Application number: 13721400.3
(22) Date of filing: 18.03.2013
(51) Int. Cl.: H01L 33/16, H01L 33/12, H01L 33/44, H01L 33/32

(54) **LIGHT EMITTING DEVICE GROWN ON A SILICON SUBSTRATE**
AUF EINEM SILICIUMSUBSTRAT GEZÜCHTETES LICHTEMITTIERENDES BAUELEMENT
DISPOSITIF ÉLECTROLUMINESCENT OBTENU PAR CROISSANCE SUR UN SUBSTRAT AU SILICIUM

(30) Priority: 19.03.2012 US 201261612536 P
(43) Date of publication of application: 28.01.2015
(73) Proprietor: Lumileds Holding B.V., 1118 BG Schiphol (NL)
(72) Inventor: SINGH, Rajwinder, NL-5656 AE Eindhoven (NL); EPLER, John, Edward, NL-5656 AE Eindhoven (NL)
(74) Representative: Rüber, Bernhard Jakob
(86) International application number: PCT/IB2013/052137
(87) International publication number: WO 2013/140320

(56) References cited:
- EP-A2- 2 421 058
- WO-A1-2005/091390
- WO-A1-2010/020069
- DE-A1-102008 030 584
- US-A1- 2005 093 008
- US-A1- 2007 105 260
- US-A1- 2009 250 684
- US-A1- 2011 079 800
- US-A1- 2011 272 720

## Description

### Field of the invention

The present invention relates to a semiconductor light emitting device such as a III-nitride light emitting diode grown on a silicon substrate.

### Background

Semiconductor light-emitting devices including light emitting diodes (LEDs), resonant cavity light emitting diodes (RCLEDs), vertical cavity laser diodes such as surface-emitting lasers (VCSELs), and edge emitting lasers are among the most efficient light sources currently available. Materials systems currently of interest in the manufacture of high-brightness light emitting devices capable of operation across the visible spectrum include Group III-V semiconductors, particularly binary, ternary, and quaternary alloys of gallium, aluminum, boron, indium, and nitrogen, also referred to as III nitride materials. Typically, III-nitride light emitting devices are fabricated by epitaxially growing a stack of semiconductor layers of different compositions and dopant concentrations on a sapphire, silicon carbide, silicon, III-nitride, or other suitable substrate by metal-organic chemical vapor deposition (MOCVD), molecular beam epitaxy (MBE), or other epitaxial techniques. The stack often includes one or more n-type layers doped with, for example, Si, formed over the substrate, one or more light emitting layers in an active region formed over the n-type layer or layers, and one or more p-type layers doped with, for example, Mg, formed over the active region. Electrical contacts are formed on the n- and p-type regions.

Fig. 1 illustrates a flip chip LED described in more detail in US 7,256,483. The LED includes n-type layers 16, an active layer 18, and p-type layers 20 grown on a sapphire growth substrate (not shown). Portions of the p-layer 20 and active layer 18 are etched away during the LED forming process, and metal 50 (metallization layer plus bonding metal) contacts the n-layer 16 on the same side as the p-contact metal 24. An underfill material 52 may be deposited in the voids beneath the LED to reduce thermal gradients across the LED, add mechanical strength to the attachment between the LED and the package substrate, and prevent contaminants from contacting the LED material. The n-metal 50 and p-metal 24 are bonded to the pads 22A and 22B, respectively, on a package substrate 12. Contact pads 22A and 22B on package substrate 12 are connected to solderable electrodes 26A and 26B using vias 28A and 28B and/or metal traces. The growth substrate is removed, exposing a surface of n-type layer 16. This surface is roughened for increased light extraction, for example by photo-electrochemical etching using a KOH solution.

EP 2 421 058 A2 discloses a light-emitting device including a transparent substrate with a light emitting structure formed on one side of the substrate and a transparent layer formed on the opposing side of the substrate. The substrate may be aluminum containing, for instance AlN. The surface of the transparent layer may be roughened.

US 2011/0272720 A1 discloses a light emitting device comprising a semiconductor structure, a seed layer and a bonding layer between the seed layer and a substrate including a wavelength converting element. A nanoporous GaN layer may be disposed in an n-type layer of the semiconductor structure.

### Summary

It is an object of the invention to provide a light emitting device grown on a silicon substrate that exhibits improved light extraction.

The device of the invention is defined in claim 1 and the method of the invention is defined in claim 11. Embodiments of the invention are defined by the dependent claims.

Embodiments of the invention include a semiconductor structure, the semiconductor structure including a III-nitride light emitting layer disposed between an n-type region and a p-type region, and an aluminum-containing layer. The aluminum-containing layer forms the top surface of the semiconductor structure. A transparent material is disposed on the aluminum-containing layer. A surface of the transparent material is patterned, roughened, or textured. A waveguide-interrupting scattering structure is disposed between the semiconductor structure and the aluminum containing layer.

A method according embodiments of the invention includes growing a semiconductor structure on a substrate including silicon. The semiconductor substrate includes an aluminum-containing layer in direct contact with the substrate, and a III-nitride light emitting layer disposed between an n-type region and a p-type region. The method further includes removing the substrate. After removing the substrate, a transparent material is formed in direct contact with the aluminum-containing layer. The transparent material is patterned, roughened, or textured. The method also includes forming a waveguide-interrupting scattering structure between the semiconductor structure and the aluminum containing layer.

Embodiments of the invention include a semiconductor structure including a III-nitride light emitting layer disposed between an n-type region and a p-type region. The semiconductor structure further includes an aluminum-containing layer. A porous III-nitride region is disposed between the aluminum-containing layer and the III-nitride light emitting layer.

### Brief description of the drawings

Fig. 1 illustrates a flip chip LED with a roughened top surface.
Fig. 2 illustrates a III-nitride structure grown on a silicon substrate.
Fig. 3 illustrates the structure of Fig. 2 attached to a support in a flip chip configuration.
Fig. 4 illustrates a portion of the top surface of a device including a roughened transparent material disposed on the semiconductor structure of Fig. 3.
Fig. 5 illustrates a portion of a semiconductor structure including a porous layer disposed between preparation layers and a device structure.
Fig. 6 illustrates a device including a waveguide-interupting region and a scattering structure.
Fig. 7 illustrates the growth of pores in a porous III-nitride layer.
Fig. 8 illustrates an apparatus for forming a porous III-nitride layer.

### Detailed description

This disclosure comprises embodiments, some of which are embodiments of the invention as defined by the appended claims.

Though the examples below refer to III-nitride LEDs that emit blue or UV light, semiconductor light emitting devices besides LEDs such as laser diodes, and semiconductor light emitting devices made from other materials systems such as other III-V materials, III-phosphide, and III-arsenide materials may be used in the embodiments.

III-nitride devices are often grown on sapphire or SiC substrates. These substrates can be removed, as described above, by etching, laser lift-off, or any other suitable technique. The III-nitride material exposed by removing these substrates is usually GaN, which can be easily roughened, for example by photoelectrochemical etching.

Silicon is an attractive substrate for growth of III-nitride devices due to its low cost, wide availability, and well-characterized electrical and thermal properties. Silicon has not been widely used as a substrate for growth of III-nitride devices due to material quality problems including cracking resulting from the lattice mismatch and thermal mismatch between III-nitride material and silicon. In addition, chemical interaction between Ga and Si requires that the first growth layer be essentially Ga-free. AlN is typically used as the first growth layer. The AlN first growth layer induces compressive strain in the GaN layers grown over the AlN first growth layer. The mismatch in thermal expansion between Si and GaN induces a tensile strain in the GaN during cool down of the wafer from the high growth temperature. By growing in a compressive state at high temperature the tensile strain generated by the cool down is accommodated.

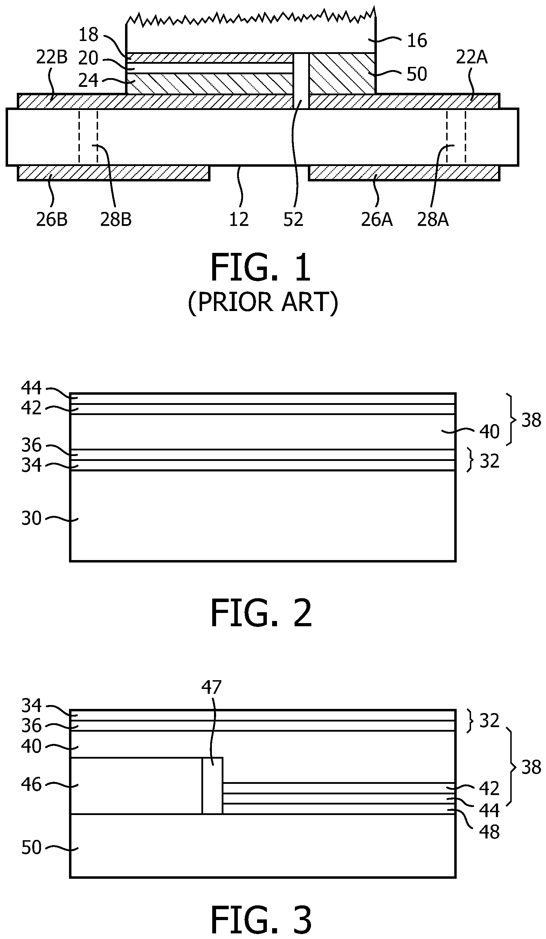

Fig. 2 illustrates a III-nitride structure grown on a silicon substrate 30. In the embodiments described herein, the silicon substrate 30 may be a silicon wafer or a composite substrate such as a silicon-on-insulator substrate where the growth surface (i.e. the top surface) is silicon. In order to reduce or eliminate the problems associated with the lattice and thermal mismatch, one or more preparation layers 32 are grown first on silicon substrate 30. In Fig. 2, two preparation layers are illustrated, an AlN seed layer 34 and an AlGaN buffer layer 36. AlN seed layer 34 may be, for example, an AlN layer less than 100 nm thick and deposited at a temperature below the growth temperature of GaN, which is often greater than 900 °C. AlGaN buffer layer 36 may be, for example, a substantially single crystal layer grown at a high temperature, for example greater than 800 °C. AlGaN buffer layer 36 may generate compressive stress in the III-nitride device structure 38, particularly in n-type region 40, which may reduce cracking in III-nitride device structure 38. In some embodiments, AlGaN buffer layer 36 is omitted, and III-nitride device structure 38 is grown directly on AlN seed layer 34. A III-nitride device structure 38, including an n-type region 40, a light emitting region 42, and a p-type region 44, is grown on preparation layers 32. The III-nitride device structure 38 is described in more detail below.

The aluminum-containing preparation layers 32, as described above, may reduce or eliminate problems associated with lattice and thermal mismatch. However, the aluminum-containing preparation layers 32 are problematic for several reasons. First, as described above in reference to Fig. 1, in some devices, the growth substrate is removed and the semiconductor structure exposed by removing the growth substrate is roughened or patterned to improve light extraction. Unlike GaN, which is often the III-nitride surface exposed by removing a conventional sapphire or SiC growth substrate, the AlN seed layer 34 described above is difficult to roughen with common techniques such as wet etching and photoelectrochemical etching. AlN must be roughened or removed by dry etching, which is an aggressive process that can damage the semiconductor structure and thereby reduce wafer yields. Second, the low index of refraction of the aluminum-containing preparation layers 32 (AlN has an index of refraction of ∼2.2), may cause light generated in the higher index, largely GaN (index of refraction of ∼2.4) device structure 38 to be lost to internal waveguiding along the interface between the aluminum-containing preparation layers 32 and the device structure 38.

Embodiments of the invention may reduce or eliminate the problems associated with the aluminum-containing preparation layers in a III-nitride device grown on a Si substrate.

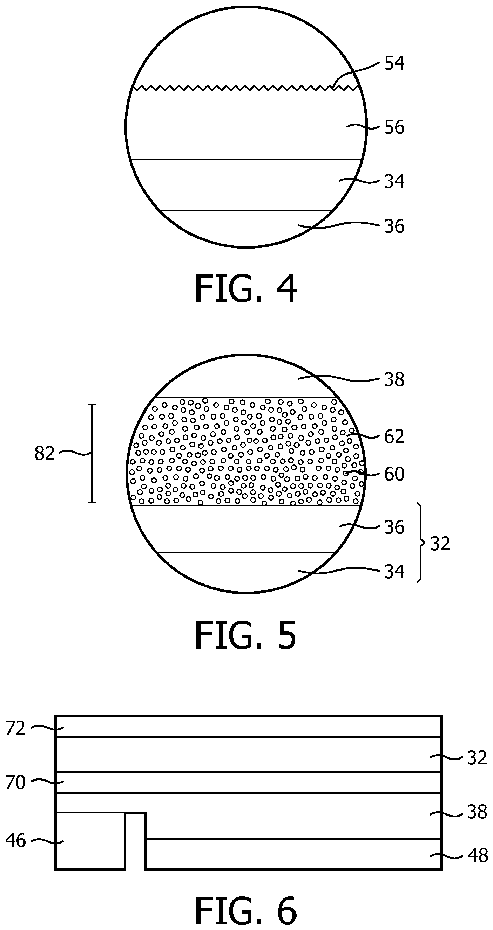

Fig. 6 illustrates a device according to embodiments of the invention. In the device illustrated in Fig. 6, the semiconductor structure is flipped relative to the growth direction of the III-nitride layers and n- and p-contacts 46 and 48 are formed on the semiconductor structure in a flip chip manner as is known in the art. In order to address the problem of the difficulty of roughening the aluminum-containing preparation layers for light extraction after removing the silicon substrate, the device illustrated in Fig. 6 includes a scattering structure 72 formed on the preparation layers 32 after the silicon substrate 30 is removed. Scattering structure 72 may be, for example, a roughened silicon oxide or silicon nitride layer, as described below. In order to address the problem of waveguiding along the interface between the aluminum-containing preparation layers 32 and device structure 38, the device of Fig. 6 includes a waveguide-interrupting scattering structure 70 between the preparation layers 32 and device structure 38. Scattering structure 70 may be, for example, a porous III-nitride layer or a roughened, patterned, or textured III-nitride layer, as described below.

The device illustrated in Fig. 6 may be formed as follows. As described above in reference to Fig. 2, preparation layers 32 are grown first on silicon substrate 30. After preparation layers 32 are grown, in some embodiments, scattering structure 70 is formed.

Scattering structure 70 may be a roughened, patterned, or textured III-nitride layer. In some embodiments, AlN seed layer 34 and AlGaN buffer layer 36 are grown, then the wafer is removed from the reactor and processed, for example by etching or mechanical techniques, to create a roughened, textured, or patterned non-planar surface on the AlGaN buffer layer 36. The wafer is then returned to the growth chamber and the device structure 38, described below, is grown over the non-planar surface of AlGaN buffer layer 36. In devices where AlGaN buffer layer 36 is omitted, the surface of AlN seed layer 34 may be made non-planar before growth of the device structure 38. The roughened, textured, or patterned surface may increase the amount of scattering at the interface, which may reduce the amount of light lost to waveguiding at the interface.

Scattering structure 70 may be a region of porous semiconductor material 60 formed between preparation layers 32 and device structure 38, as illustrated in Fig. 5. Porous region 60 may increase the amount of scattering at the interface, which may reduce the amount of light lost to waveguiding at the interface.

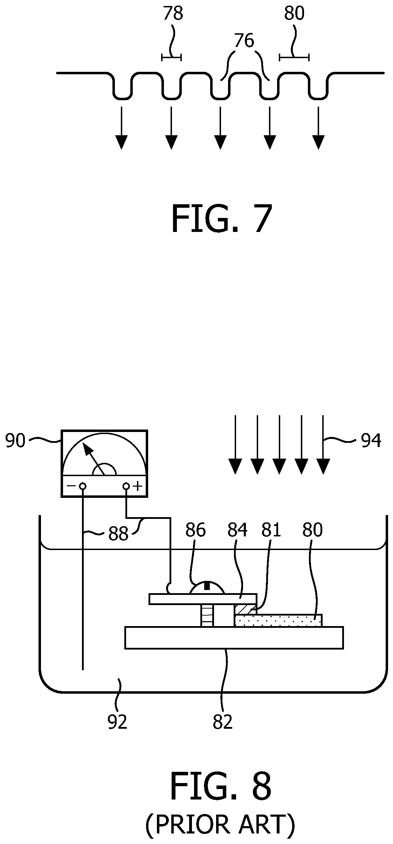

Porous region 60 may be formed by any suitable technique, as is known in the art. For example, porous region 60 may be formed as follows: one or more aluminum-containing preparation layers 32 are grown on the Si growth substrate, as described above. A III-nitride layer 62 which will be made porous, often GaN but any suitable III-nitride material including but not limited to AlGaN and InGaN, is grown over the preparation layers 32. An arrangement for making III-nitride layer 62 porous is illustrated in Fig. 8. Silver 81 is deposited by thermal evaporation in a region of the top surface of semiconductor structure 80, which includes III-nitride layer 62, preparation layers 32, and silicon substrate 30. The wafer 80 is placed on a Teflon surface 82. Silver area 81 is contacted with a washer 84 and the semiconductor structure 80 is secured to Teflon surface 82 with a bolt 86. In an anodic etching process, a platinum wires 88 serving as the anode and cathode are connected to a power supply 90. The anode wire is connected to washer 84. The wafer 80 and platinum wires 88 are immersed in a 2M NaOH or KOH solution 92. A direct current is applied through the wire and wafer, for example at a density between 10 and 20 mA/cm². Optional UV-illumination 94 is supplied by a 250 W mercury lamp. An appropriate porosity may require 10 to 60 minutes of processing, after which the lamp and the current source are switched off. Alternatively, platinum may be applied directly over the surface of the wafer, or different solutions such as KOH, fluoride acids, or CH₃OH:HF:H₂O₂ are used in a photo-electro-chemically driven process. The density and size of the porosity may be controlled by varying the concentration of the solution. A small pore layer may be produced with a low molarity solution (0.5% KOH). A large pore layer beneath the surface may be produced with a high molarity solution (2% KOH).

Fig. 7 illustrates the growth of pores 76. The etching almost exclusively occurs at the tips of the electrolyte-semiconductor interface, at the ends of the pores 76, such that the pores grow downward from the bottoms of the pores, as illustrated by the arrows in Fig. 7. By altering the solution during etching, a multilayer porosity may be created.

In porous region 60 as illustrated in Fig. 7, air voids 76 are formed in the III-nitride material. The voids may have a width 78 on the order of tens to hundreds of nm in size, for example greater than 10 nm in size in some embodiments and less than 500 nm in size in some embodiments. Nearest neighbor voids may have a spacing 80 on the order of tens to hundreds of nm apart, for example greater than 10 nm apart in some embodiments and less than 500 nm apart in some embodiments. Porous region 60, as illustrated in Fig. 5, may have a thickness 82 greater than 0.02 µm thick in some embodiments and less than 3 µm thick in some embodiments. The percent porosity, defined as the volume of voids as a percent of the total volume of porous region 60, may be greater than 20% in some embodiments, less than 80% in some embodiments, and greater than 50% in some embodiments. The pores may be, in some embodiments, substantially parallel tunnels that extend from the surface of porous region 60 toward preparation layers 32. Scattering is caused by the difference in index of refraction between the III-nitride material and the ambient gas inside the pores.

The thickness of the III-nitride layer 62 which is made into porous region 60 may be, for example, greater than 0.5 µm in some embodiments, less than 5 µm in some embodiments, less than 2 µm in some embodiments, between 0.5 and 1.5 µm in some embodiments, and 1µm in some embodiments. The III-nitride layer is often n-type GaN though in some embodiments it may be undoped or p-type material. The entire thickness of III-nitride layer 62 may be made porous in some embodiments, or less than the entire thickness of III-nitride layer 62 may be made porous in some embodiments, such that a nonporous region of III-nitride layer 62 is disposed between porous region 60 and preparation layers 32. In some embodiments, porous region 60 extends into preparation layers 32. After forming the porous region 60, the structure is returned to a growth reactor and the device structure 38 is grown, as described below.

A III-nitride device structure 38 is grown over any of the structures described above: preparation layers 32 without roughening or texturing, roughened or textured preparation layers 32, or porous region 60. The device structure 38 includes a light emitting or active region 42, often including at least one InGaN light emitting layer, sandwiched between n- and p-type regions 40 and 44, each typically including at least one GaN layer. An n-type region 40 may be grown first and may include multiple layers of different compositions and dopant concentration including, for example, layers which may be n-type or not intentionally doped, and n- or even p-type device layers designed for particular optical, material, or electrical properties desirable for the light emitting region to efficiently emit light. A light emitting or active region 42 is grown over the n-type region 40. Examples of suitable light emitting regions 42 include a single thick or thin light emitting layer, or a multiple quantum well light emitting region including multiple thin or thick light emitting layers separated by barrier layers. A p-type region 44 may then be grown over the light emitting region 42. Like the n-type region 40, the p-type region 44 may include multiple layers of different composition, thickness, and dopant concentration, including layers that are not intentionally doped, or n-type layers. The total thickness of all the layers grown on substrate 30, including regions 32 and 38, may be less than 10 µm in some embodiments and less than 6 µm in some embodiments.

After growth of device structure 38, a wafer including substrate 30 and the semiconductor structures 32 and 38 grown on the substrate may be further processed. For example, to form flip chip LEDs, a reflective metal p-contact is formed on the p-type region 44. The device structure 38 is then patterned by standard photolithographic operations and etched to remove, for each LED, a portion of the entire thickness of the p-type region 44 and a portion of the entire thickness of the light emitting region 42, to form a mesa which reveals a surface of the n-type region 40 on which a metal n-contact is formed. The mesa and p- and n-contacts may be formed in any suitable manner. Forming the mesa and p- and n-contacts is well known to a person of skill in the art.

The wafer may then be singulated into individual devices which are individually attached to supports, or attached to a support on a wafer scale, before singulation. The support is a structure that mechanically supports the semiconductor structure. Examples of suitable supports include an insulating or semi-insulating wafer with conductive vias for forming electrical connections to the semiconductor structure, such as a silicon wafer, thick metal bonding pads formed on the semiconductor structure, for example by plating, or a ceramic, metal, or any other suitable mount. After attaching the semiconductor structure to a support, before or after singulating, the growth substrate may be removed from the III-nitride structure.

Fig. 3 illustrates a flip chip device attached to a support, with the growth substrate removed. The device structure 38 is attached to support 50 through metal n-contact 46 and metal p-contact 48. The n- and p-contacts may be electrically isolated by a gap 47, which may be filled with air, ambient gas, or a solid insulating material such as an oxide of silicon, silicone, or epoxy. The surface of grown semiconductor material exposed by removing the silicon growth substrate 30 is the surface of AlN seed layer 34. Because one or both of contacts 46 and 48 are reflective, a majority of light escapes the structure of Fig. 3 through the top and side surfaces.

In order to avoid the damage caused by roughening, texturing, or removing the AlN seed layer exposed after removing the growth substrate as described above, in some embodiments a layer of roughened material is formed on the surface of the semiconductor structure revealed by removing the growth substrate. Fig. 4 illustrates a portion of a device according to embodiments of the invention. As described above, when the growth substrate is removed, the surface of AlN seed layer 34 is exposed. In the structure illustrated in Fig. 4, a layer 56 of optically transparent material that has an index of refraction that is close to or matches the index of refraction of AlN seed layer 34 is formed over the surface of AlN seed layer 34. The top surface 54 of layer 56 is roughened to enhance light extraction from the semiconductor structure.

Transparent material 56 is selected to be transparent to light emitted by the light emitting region, such that absorption or scattering by transparent material 52 is nominal. The refractive index of transparent material 56 is at least 1.9 in some embodiments, at least 2.0 in some embodiments, and at least 2.1 in some embodiments, such that the refractive index of transparent material 56 is close to the refractive indices of AlN seed layer 34 (refractive index of 2.2) and any GaN layers in device structure 38 (refractive index of 2.4). Examples of suitable transparent materials 56 include non-III-nitride materials, oxides of silicon, nitrides of silicon, oxynitrides of silicon, SiO₂, Si₃N₄, SiOₓN_{y}, and mixtures thereof. Transparent material 56 may be a multi-layer structure in some embodiments. Transparent material 56 may be formed by, for example, chemical vapor deposition or any other suitable technique.

The surface 54 of transparent material 56 may be patterned, roughened, or textured by any suitable technique or combination of techniques including, for example, dry or wet etching, and dry or wet etching utilizing self-masking, patterned masking, lithographic patterning, microsphere patterning, or any other suitable masking technique. For example, a Si₃N₄ layer 56 may be patterned with random or regular features using known photolithography techniques such as i-line photoresist patterning, followed by CHF₃ plasma etching, as is known in the art. In some embodiments, the patterning, texturing, or roughening extends through an entire thickness of transparent material 56 to the surface of seed layer 34.

In some embodiments, one or more additional, optional structures may be formed over the roughened surface 54 of transparent layer 56. For example, one or more wavelength converting materials, optics, filters such as dichroic filters, or other structures may be disposed over transparent layer 56, in contact with transparent layer 56 or spaced apart from transparent layer 56.

## Claims

1. A device comprising:
a semiconductor structure (38) comprising:
a III-nitride light emitting layer (42) disposed between an n-type region (40) and a p-type region (44);
an aluminum-containing layer (32); and
a transparent material (56),
wherein the aluminum containing layer (32) is disposed between the semiconductor structure (38) and the transparent material (56); and
wherein a surface (54) of the transparent material is patterned, roughened, or textured,
**characterized by**,
a waveguide-interrupting scattering structure (70) between the semiconductor structure (38) and the aluminum containing layer (32).

2. The device of claim 1 wherein the aluminum-containing layer (32) is AlN.

3. The device of claim 1 wherein the n-type region (40) is disposed between the aluminum-containing layer (32) and the III-nitride light emitting layer (42).

4. The device of claim 1 wherein the transparent material (56) has an index of refraction of at least 2.0.

5. The device of claim 1 wherein the transparent material (56) comprises an oxide of silicon.

6. The device of claim 1 wherein the transparent material (56) comprises a nitride of silicon.

7. The device of claim 1 wherein a surface of the aluminum-containing layer (32) facing the semiconductor structure is non-planar.

8. The device of claim 7 wherein the non-planar surface is a surface of an AlGaN layer between the AlGaN layer and a GaN layer that is part of the n-type region.

9. The device of claim 1, wherein the waveguide-interrupting scattering structure (70) comprises a porous semiconductor layer.

10. The device of claim 1, wherein the waveguide-interrupting scattering structure (70) comprises a roughened, patterned, or textured III-nitride layer.

11. A method comprising:
growing a semiconductor structure (38) on a substrate (30) comprising silicon, the semiconductor structure comprising:
an aluminum-containing layer (32) in direct contact with the substrate (30); and
a III-nitride light emitting layer (42) disposed between an n-type region (40) and a p-type region (44);
removing the substrate (30);
after removing the substrate (30), forming a transparent material (56) in direct contact with the aluminum-containing layer (32); and
roughening, texturing, or patterning a surface (54) of the transparent material (56),
**characterized by**,
forming a waveguide-interrupting scattering structure (70) between the semiconductor structure (38) and the aluminum containing layer (32).

12. The method of claim 11 wherein the substrate comprises (30) a silicon layer.

13. The method of claim 11 wherein the aluminum-containing layer (32) is AlN.

14. The method of claim 12 wherein the transparent material (56) has an index of refraction of at least 2.0.

15. The method of claim 11 wherein the transparent material (56) is formed by chemical vapor deposition.

16. The method of claim 11 wherein the transparent material (56) is a non-III-nitride material.

17. The method of claim 11 further comprising:
after growing the aluminum-containing layer (32), forming a non-planar surface on the semiconductor structure;
after forming the non-planar surface, growing the III-nitride light emitting layer (42) disposed between the n-type region (40) and the p-type region (44).

18. The method of claim 11 further comprising:
after growing the aluminum-containing layer (32), providing the waveguide-interrupting scattering structure (70) by forming a porous GaN layer;
after forming the porous GaN layer, growing the III-nitride light emitting layer (42) disposed between the n-type region (40) and the p-type region (42).

## Patentansprüche

1. Vorrichtung, umfassend:
eine Halbleiterstruktur (38), umfassend:
eine III-Nitrid-Licht emittierende Schicht (42), die zwischen einer n-Typ-Region (40) und einer p-Typ-Region (44) angeordnet ist;
eine Aluminium-enthaltende Schicht (32); und
ein transparentes Material (56),
wobei die Aluminium-enthaltende Schicht (32) zwischen der Halbleiterstruktur (38) und dem transparenten Material (56) angeordnet ist; und
wobei eine Oberfläche (54) des transparenten Materials gemustert, aufgerauht oder strukturiert ist,
**gekennzeichnet durch**
eine Wellenleiter-unterbrechende, zerstreuende Struktur (70) zwischen der Halbleiterstruktur (38) und der Aluminium-enthaltenden Struktur (32).

2. Vorrichtung nach Anspruch 1, wobei die Aluminium-enthaltende Schicht (32) AN ist.

3. Vorrichtung nach Anspruch 1, wobei die n-Typ-Region (40) zwischen der Aluminium-enthaltenden Schicht (32). und der III-Nitrid-Licht emittierenden Schicht (42) angeordnet ist.

4. Vorrichtung nach Anspruch 1, wobei das transparente Material (56) einen Brechungsindex von mindestens 2,0 aufweist.

5. Vorrichtung nach Anspruch 1, wobei das transparente Material (56) ein Oxid von Silicium umfasst.

6. Vorrichtung nach Anspruch 1, wobei das transparente Material (56) ein Nitrid von Silicium umfasst.

7. Vorrichtung nach Anspruch 1, wobei eine Oberfläche der Aluminium-enthaltenden Schicht (32), die der Halbleiterstruktur gegenüber liegt, nicht planar ist.

8. Vorrichtung nach Anspruch 7, wobei die nicht planare Oberfläche eine Oberfläche einer AIGaN-Schicht zwischen der AlGaN-Schicht und einer GaN-Schicht ist, die Teil der n-Typ-Region ist.

9. Vorrichtung nach Anspruch 1, wobei die Wellenleiter-unterbrechende, zerstreuende Struktur (70) eine poröse Halbleiterschicht umfasst.

10. Vorrichtung nach Anspruch 1, wobei die Wellenleiter-unterbrechende, zerstreuende Struktur (70) eine aufgerauhte, gemusterte oder strukturierte III-Nitrid-Schicht umfasst.

11. Verfahren, umfassend:
Züchten einer Halbleiterstruktur (38) auf einem Substrat (30), umfassend Silicium, wobei die Halbleiterstruktur Folgendes umfasst:
eine Aluminium-enthaltende Schicht (32) in direktem Kontakt mit dem Substrat (30); und
eine III-Nitrid-Licht emittierende Schicht (42), die zwischen einer n-Typ-Region (40) und einer p-Typ-Region (44) angeordnet ist;
Entfernen des Substrats (30);
nach dem Entfernen des Substrats (30) Bilden eines transparenten Materials (56) in direktem Kontakt mit der Aluminium-enthaltenden Schicht (32); und
Aufrauhen, Strukturieren oder Mustern einer Oberfläche (54) des transparenten Materials (56),
**gekennzeichnet durch**
Bilden einer Wellenleiter-unterbrechenden, zerstreuenden Struktur (70) zwischen der Halbleiterstruktur (38) und der Aluminium-enthaltenden Struktur (32).

12. Verfahren nach Anspruch 11, wobei das Substrat eine Siliciumschicht (30) umfasst.

13. Verfahren nach Anspruch 11, wobei die Aluminium-enthaltende Schicht (32) AN ist.

14. Verfahren nach Anspruch 12, wobei das transparente Material (56) einen Brechungsindex von mindestens 2,0 aufweist.

15. Verfahren nach Anspruch 11, wobei das transparente Material (56) durch eine chemische Dampfablage gebildet ist.

16. Verfahren nach Anspruch 11, wobei das transparente Material (56) ein Nicht-III-Nitridmaterial ist.

17. Verfahren nach Anspruch 11, weiter umfassend
nach dem Züchten der Aluminium-enthaltenden Schicht (32), Bilden einer nicht planaren Oberfläche auf der Hableiterstruktur;
nach dem Bilden der nicht planaren Oberfläche, Züchten der III-Nitrid-Licht emittierenden Schicht (42), die zwischen der n-Typ-Region (40) und der p-Typ-Region (44) angeordnet ist.

18. Verfahren nach Anspruch 11, weiter umfassend
nach dem Züchten der Aluminium-enthaltenden Schicht (32), Bereitstellen der Wellenleiter-unterbrechenden, zerstreuenden Struktur (70) durch Bilden einer porösen GaN-Schicht;
nach dem Bilden der porösen GaN-Schicht, Züchten der III-Nitrid-Licht emittierenden Schicht (42), die zwischen der n-Typ-Region (40) und der p-Typ-Region (42) angeordnet ist.

## Revendications

1. Dispositif comprenant :
une structure semi-conductrice (38) comprenant :
une couche électroluminescente de nitrure d'élément III (42) disposée entre une région de type n (40) et une région de type p (44) ;
une couche contenant de l'aluminium (32) ; et
un matériau transparent (56),
dans lequel la couche contenant de l'aluminium (32) est disposée entre la structure semi-conductrice (38) et le matériau transparent (56) ; et
dans lequel une surface (54) du matériau transparent est structurée, dépolie ou texturée,
**caractérisé en ce qu'**il comprend
une structure de diffusion à interruption de guide d'ondes (70) entre la structure semi-conductrice (38) et la couche contenant de l'aluminium (32).

2. Dispositif selon la revendication 1 dans lequel la couche contenant de l'aluminium (32) est en AlN.

3. Dispositif selon la revendication 1 dans lequel la région de type n (40) est disposée entre la couche contenant de l'aluminium (32) et la couche électroluminescente de nitrure d'élément III (42).

4. Dispositif selon la revendication 1 dans lequel le matériau transparent (56) a un indice de réfraction d'au moins 2,0.

5. Dispositif selon la revendication 1 dans lequel le matériau transparent (56) comprend un oxyde de silicium.

6. Dispositif selon la revendication 1 dans lequel le matériau transparent (56) comprend un nitrure de silicium.

7. Dispositif selon la revendication 1 dans lequel une surface de la couche contenant de l'aluminium (32) faisant face à la structure semi-conductrice n'est pas plane.

8. Dispositif selon la revendication 7 dans lequel la surface non plane est une surface d'une couche de AlGaN entre la couche de AlGaN et une couche de GaN qui fait partie de la région de type n.

9. Dispositif selon la revendication 1 dans lequel la structure de diffusion à interruption de guide d'ondes (70) comprend une couche semi-conductrice poreuse.

10. Dispositif selon la revendication 1, dans lequel la structure de diffusion à interruption de guide d'ondes (70) comprend une couche de nitrure d'élément III dépolie, structurée ou texturée.

11. Procédé comprenant :
la croissance d'une structure semi-conductrice (38) sur un substrat (30) comprenant du silicium, la structure semi-conductrice comprenant :
une couche contenant de l'aluminium (32) en contact direct avec le substrat (30) ; et
une couche électroluminescente de nitrure d'élément III (42) disposée entre une région de type n (40) et une région de type p (44) ;
le retrait du substrat (30) ;
après retrait du substrat (30), la formation d'un matériau transparent (56) en contact direct avec la couche contenant de l'aluminium (32) ; et
le dépolissage, la texturation ou la structuration d'une surface (54) du matériau transparent (56),
**caractérisé en ce qu'**il comprend
la formation d'une structure de diffusion à interruption de guide d'ondes (70) entre la structure semi-conductrice (38) et la couche contenant de l'aluminium (32).

12. Procédé selon la revendication 11 dans lequel le substrat (30) comprend une couche de silicium.

13. Procédé selon la revendication 11 dans lequel la couche contenant de l'aluminium (32) est en AlN.

14. Procédé selon la revendication 12 dans lequel le matériau transparent (56) a un indice de réfraction d'au moins 2,0.

15. Procédé selon la revendication 11 dans lequel le matériau transparent (56) est formé par dépôt chimique en phase vapeur.

16. Procédé selon la revendication 11 dans lequel le matériau transparent (56) n'est pas un nitrure d'élément III.

17. Procédé selon la revendication 11 comprenant en outre :
après croissance de la couche contenant de l'aluminium (32), la formation d'une surface non plane sur la structure semi-conductrice ;
après formation de la surface non plane, la croissance de la couche électroluminescente de nitrure d'élément III (42) disposée entre la région de type n (40) et la région de type p (44).

18. Procédé selon la revendication 11 comprenant en outre :
après croissance de la couche contenant de l'aluminium (32), la fourniture de la structure de diffusion à interruption de guide d'ondes (70) par formation d'une couche de GaN poreuse ;
après formation de la couche de GaN poreuse, la croissance de la couche électroluminescente de nitrure d'élément III (42) disposée entre la région de type n (40) et la région de type p (42).
